# EUROPÄISCHE PATENTSCHRIFT

(11) **EP 1 435 677 B1**
(45) Veröffentlichungstag und Bekanntmachung des Hinweises auf die Patenterteilung: **07.11.2007**
(21) Anmeldenummer: 03030013.1
(22) Anmeldetag: 30.12.2003
(51) Int. Cl.: H01R 12/22

(54) **Elektrischer Verbinder und elektrische oder elektronische Baugruppe mit elektrischem Verbinder**
Electrical connector and electrical or electronical assembly with an electrical connector
Connecteur électrique et assemblage électrique ou électronique avec un connecteur électrique

(30) Priorität: 02.01.2003 DE 10300006
(43) Veröffentlichungstag der Anmeldung: 07.07.2004
(73) Patentinhaber: Delphi Technologies, Inc., Troy, MI 48007 (US)
(72) Erfinder: Hombach, Frank, 51674 Wiehl (DE); Hupertz, Stefan, 57462 Olpe (DE); Noll, Diethelm, 57589 Birkrnbeul (DE)
(74) Vertreter: Manitz, Finsterwald & Partner GbR

(56) Entgegenhaltungen:
- DE-A1- 4 225 358
- DE-A1- 10 059 761
- US-A- 5 797 757

## Beschreibung

Die vorliegende Erfindung betrifft einer Leiterplatte sowie eine elektrische oder elektronische Baugruppe mit einer Leiterplatte, einer darauf wenigstens teilweise angeordneten elektrischen oder elektronischen Schaltung und einem auf der Leiterplatte befestigten elektrischen Verbinder.

Elektrische Verbraucher, beispielsweise in Kraftfahrzeugen, werden häufig elektronisch ein- und ausgeschaltet. Hierzu sind entsprechende Baugruppen vorgesehen, die eine auf einer Leiterplatte angeordnete Schaltung aufweisen, die mit einem auf der Leiterplatte gehaltenen Steckverbinder verbunden ist. Über diesen Steckverbinder ist die Schaltung auf der Leiterplatte zum einen mit einer Spannungs- bzw. Stromquelle und zum anderen mit entsprechenden Stromzuführungen zu den elektrischen Verbrauchern verbindbar. Darüber hinaus können über den Steckverbinder Steuerleitungen mit der Schaltung verbunden werden.

Die elektronische Schaltung auf der Leiterplatte umfasst in der Regel elektrische und/oder elektronische Schaltelemente, mittels derer die vergleichsweise hohen Ströme zu den elektrischen Verbrauchern in Abhängigkeit von Steuersignalen auf den Steuerleitungen schaltbar sind. Die Ströme zu den Verbrauchern und damit auch der der Schaltung zugeführte Gesamtstrom sind im Vergleich zu den über die Steuerleitungen zugeführten Steuerströmen groß. Die hohe Ströme führenden Anschlüsse der elektrischen und/oder elektronischen Schaltelemente müssen daher über entsprechende dicke und/oder breite Leiterbahnen mit entsprechenden Kontakten des auf der Leiterplatte befestigten Steckverbinders verbunden sein, um die vergleichsweise hohen Ströme mit nur geringen Verlusten und einer nur geringen Wärmebelastung zwischen dem Steckverbinder und der Schaltung zu führen.

Die Herstellung solcher breiten und/oder dicken Leiterbahnen ist jedoch aufwändig und erfordert einen erheblichen Materialeinsatz. Darüber hinaus beanspruchen breite Leiterbahnen auch eine erhebliche Fläche, die einen sehr kompakten Aufbau der entsprechenden Leiterplatte verhindert.

Aus der US-A-5,797,757 ist ein elektrischer Verbinder zum Befestigen auf einer Leiterplatte bekannt. Oberhalb der Leiterplatte ist über elektrisch leitende Abstandshalter eine in eine Karte integrierte Busverbindung vorgesehen, wobei ein auf der Leiterplatte befestigbares Gehäuse vorgesehen ist. Ferner ist eine Stromschiene vorgesehen, die einerseits mit der Leiterplatte verlötet ist und die andererseits mit den Bus-Leitern der Karte verbindbar ist. Die entgegengesetzten Enden der Busschiene sind in das Gehäuse des Verbinders so einführbar, dass diese als Kontaktzungen des Steckverbinders wirken.

Der vorliegenden Erfindung liegt daher die Aufgabe zugrunde, eine elektrische oder elektronische Baugruppe mit einer Leiterplatte, einer darauf wenigstens teilweise angeordneten elektrischen oder elektronischen Schaltung und einem auf der Leiterplatte befestigten elektrischen Verbinder bereitzustellen, bei der zur Führung von Verbrauchsströmen geeignete Verbindungen einfach herstellbar sind, sowie einen dazu verwendbaren Verbinder zu schaffen.

Die Aufgabe wird gelöst durch eine Baugruppe mit den Merkmalen des Anspruchs 1.

Der Verbinder zur Befestigung auf einer Leiterplatte, auf der wenigstens teilweise eine elektrische oder elektronische Schaltung angeordnet ist, und zur elektrischen Verbindung von elektrischen Leitungen mit der elektrischen oder elektronischen Schaltung umfasst ein auf der Leiterplatte befestigbares Gehäuse und eine wenigstens teilweise in oder an dem Gehäuse angeordnete, mit einer elektrischen Leitung verbindbare Stromschiene, die einen Anschlussabschnitt aufweist, wobei, wenn der Verbinder an der Leiterplatte befestigt ist, der Anschlussabschnitt an einer Oberfläche der Leiterplatte oder von der Oberfläche beabstandet so angeordnet ist, dass wenigstens ein Kontakt eines elektrischen oder elektronischen Bauelements der Schaltung mit dem Anschlussabschnitt verbindbar ist.

Die erfindungsgemäße elektrische oder elektronische Baugruppe umfasst eine Leiterplatte, eine darauf wenigstens teilweise angeordnete, elektrische oder elektronische Schaltung und einen auf der Leiterplatte befestigten erfindungsgemäßen elektrischen Verbinder, wobei wenigstens ein elektrisches oder elektronisches Bauelement der Schaltung mit dem Anschlussabschnitt der Stromschiene und einer Leiterbahn auf der Leiterplatte elektrisch verbunden ist.

Bei der Leiterplatte kann es sich um einen beliebigen Schaltungsträger handeln, auf dem elektrische oder elektronische Bauelemente befestigbar sind. Insbesondere können Leiterplatten mit gedruckten Leiterbahnen üblicher Dicke und Breite verwendet werden, jedoch ist grundsätzlich auch die Verwendung anderer Leiterbahnen denkbar.

Die elektrische oder elektronische Schaltung ist wenigstens teilweise auf der Leiterplatte angeordnet und kann insbesondere elektrische oder elektronische Bauelemente aufweisen, mittels derer Ströme zu elektrischen Verbrauchern schaltbar sind und die wenigstens teilweise über Leiterbahnen auf der Leiterplatte elektrisch verbunden sein können.

Der Verbinder dient zum Anschluss der Schaltung an entsprechende externe Leitungen. Er weist ein Gehäuse auf, das auf der Leiterplatte befestigbar ist. Die Art der Befestigung kann grundsätzlich konventionell erfolgen, insbesondere können hierzu entsprechende Verbindungselemente für eine Rast-, Schnapp- oder Schraubverbindung vorgesehen sein, wobei dann auf der Leiterplatte entsprechende komplementäre Elemente vorgesehen sind. Das Gehäuse kann jedoch auch auf der Leiterplatte aufgeklebt oder mittels Kontaktelementen, die auf der Leiterplatte verlötet werden, auf dieser befestigt sein.

Zur Führung von Strömen zu elektrischen Verbrauchern ist eine wenigstens teilweise in oder an dem Gehäuse angeordnete Stromschiene vorgesehen, die insbesondere aus einem gut elektrisch leitfähigen Material, beispielsweise Kupfer oder einer Kupferlegierung hergestellt sein kann. Diese ist zum einen mit wenigstens einer elektrischen Leitung verbindbar, über die ein entsprechender Versorgungsstrom zuführbar ist.

Zum anderen weist die Stromschiene einen Anschlussabschnitt auf, der, wenn der Verbinder an der Leiterplatte befestigt ist, an einer Oberfläche der Leiterplatte oder von der Oberfläche beabstandet angeordnet ist. Die Anordnung ist dabei derart, dass wenigstens ein Kontakt eines elektrischen oder elektronischen Bauelements der Schaltung mit dem Anschlussabschnitt verbindbar ist. Wenigstens ein Abschnitt einer Oberfläche des Anschlussabschnitts ist daher, vorzugsweise außerhalb eines Gehäuses des elektrischen Verbinders, so angeordnet, dass eine direkte Kontaktierung des Abschnitts möglich ist. Auf diese Weise kann das elektrische oder elektronische Bauelement einfach auch mit einem großen Versorgungsstrom versorgt werden, ohne dass breite und/oder dicke Leiterbahnen auf der Leiterplatte notwendig wären. Ist der Anschlussabschnitt von der Oberfläche beabstandet angeordnet, ergibt sich die Möglichkeit, die Leiterplatte auch in einem Bereich zwischen der Oberfläche und dem Anschlussabschnitt mit weiteren Leiterbahnen zu bedrucken, so dass die Leiterplatte insgesamt eine kleinere Fläche einnehmen kann.

Insbesondere ermöglicht der Verbinder die Herstellung einer erfindungsgemäßen elektrischen oder elektronischen Baugruppe, bei der das wenigstens eine elektrische oder elektronische Bauelement der Schaltung mit dem Anschlussabschnitt der Stromschiene und einer Leiterbahn auf der Leiterplatte, die insbesondere mit einem weiteren Bauelement der Schaltung oder einem Kontakt des elektrischen Verbinders verbunden sein kann, elektrisch verbunden ist. Insbesondere kann es sich bei der elektrischen Verbindung der Leiterbahn auf der Leiterplatte um eine Steuerleitung für das elektrische oder elektronische Bauelement handeln, wenn dieses beispielsweise ein elektronisches Bauelement zur Schaltung von Strömen ist.

Durch die Bereitstellung der Stromschiene zur Stromversorgung mit auch vergleichsweise großen Strömen können breite und/oder dicke Leiterbahnen vermieden werden, was nicht nur die Herstellung der erfindungsgemäßen elektrischen oder elektronischen Baugruppe erleichtert und eine entsprechende Materialersparnis mit sich bringt, sondern auch die notwendige Fläche der Leiterplatte reduziert, so dass deren Baugröße geringer wird, was insbesondere im Automobilbereich von erheblicher Bedeutung sein kann.

Weiterbildungen und bevorzugte Ausführungsformen der Erfindung sind in den Ansprüchen, der Beschreibung und den Zeichnungen beschrieben.

Die Stromschiene wird vorzugsweise zur Führung von Strömen verwendet, die im Vergleich zu Steuerströmen große Stärken annehmen können. Dazu ist es bevorzugt, dass wenigstens der Anschlussabschnitt eine Querschnittsfläche von wenigstens 1mm² aufweist. Die Querschnittsfläche ist dabei im Wesentlichen orthogonal zu der Richtung eines Stroms durch den Anschlussabschnitt orientiert.

Ein mit der Stromschiene verbundenes elektrisches oder elektronisches Bauelement der Schaltung, das mit der Stromschiene bzw. dem Anschlussabschnitt darauf verbunden ist, kann grundsätzlich auf der Leiterplatte gehalten sein. Es ist bei der erfindungsgemäßen Baugruppe jedoch bevorzugt, dass der Anschlussabschnitt der Stromschiene einen Träger für das elektrische oder elektronische Bauelement bildet. Insbesondere kann das Bauelement auf dem Anschlussabschnitt beispielsweise durch eine Klebung und/oder die elektrische Verbindung des Bauelements mit dem Anschlussabschnitt, beispielsweise eine Lötverbindung, befestigt sein. Auf diese Weise kann die Stromschiene, die zur Erzielung eines möglichst geringen Widerstands einen erheblichen Querschnitt aufweisen kann, zu einer weiteren Platzersparnis auf der Leiterplatte genutzt werden, indem auf dieser gewissermaßen eine räumlich gesehen zweite Schaltungsebene ausgebildet wird. Besonders bevorzugt weist der Anschlussabschnitt dazu eine Dicke von mehr als 0,2 mm auf. Die Dicke bezieht sich dabei auf eine Richtung, in der das Bauelement auf dem Anschlussabschnitt gehalten ist, d.h. eine Senkrechte auf eine entsprechende Oberfläche des Anschlussabschnitts. Auf diese Weise kann eine hinreichende Stabilität des Anschlussabschnitts erreicht werden.

Grundsätzlich genügt es, dass der erfindungsgemäße elektrische Verbinder nur die Stromschiene aufweist. Es ist jedoch bevorzugt, dass der elektrische Verbinder wenigstens ein Kontaktelement zur elektrischen Verbindung einer Leiterbahn und/oder einer mit der Leiterbahn elektrisch verbundenen Kontaktierungsfläche mit wenigstens einer der elektrischen Leitungen aufweist. Der erfindungsgemäße elektrische Verbinder kann dann nicht nur zur Zu- oder Abführung von gegebenenfalls auch größeren Strömen für elektrische Verbraucher dienen, sondern auch zur Zuführung von beispielsweise Steuersignalen zu der auf der Leiterplatte wenigstens teilweise angeordneten elektronischen Schaltung.

Das Kontaktelement kann dabei an einem Kontaktierungsende in an sich beliebiger Weise so ausgebildet sein, dass es mit einer der Leiterbahnen verbindbar ist. Beispielsweise kann das Kontaktierungsende als Kontaktfläche oder federnder Kontaktabschnitt, der nur auf eine entsprechende Leiterbahn oder Kontaktfläche auf der Leiterplatte aufgepresst wird, ausgebildet sein. Es ist jedoch besonders bevorzugt, dass das Kontaktelement zur Einführung in eine entsprechende Öffnung der Leiterplatte in einer Einführrichtung ausgebildet ist, und dass der Anschlussabschnitt der Stromschiene im Wesentlichen orthogonal zu der Einführrichtung orientiert ist. Bei der elektrischen oder elektronischen Baugruppe ist es entsprechend bevorzugt, dass auf der Leiterplatte ein entsprechender elektrischer Verbinder befestigt ist, dessen Kontaktelement in eine entsprechende Öffnung der Leiterplatte eingeführt und dort verlötet ist, und dass der Anschlussabschnitt der Stromschiene im Wesentlichen orthogonal zu der Einführrichtung orientiert ist. Dabei ist die Einführrichtung im Wesentlichen relativ zu einer Referenzrichtung eines Kontaktierungsendes an dem Kontaktelement definiert. Das Kontaktierungsende kann insbesondere einen stift- oder zungenartig ausgebildeten, in die Öffnung in der Leiterplatte einzuführenden Abschnitt aufweisen, so dass dann die Einführrichtung parallel zu dem stift- oder zungenförmigen Abschnitt orientiert ist. Unter der Orientierung des Anschlussabschnitts zu der Einführrichtung wird bei einem linearen Anschlussabschnitt verstanden, dass dieser im Wesentlichen orthogonal zu der Einführrichtung angeordnet ist. Der Anschlussabschnitt kann jedoch auch im Wesentlichen in einer Ebene liegend, aber nichtlinear ausgebildet sein, wobei dann unter der im Wesentlichen orthogonalen Orientierung verstanden wird, dass eine Ebene, die durch die Ausdehnung des Anschlussabschnitts definiert ist, senkrecht zu der Einführrichtung orientiert ist. Dabei kann besonders bevorzugt der Anschlussabschnitt parallel zu der Oberfläche der Leiterplatte ausgerichtet sein, wenn der Verbinder auf der Leiterplatte befestigt ist. Auf diese Weise können mehrere unabhängig voneinander zu schaltende elektrische Verbraucher durch nur eine elektronische Baugruppe mit nur einem Verbinder mit Strom versorgt werden.

Bevorzugt dient die Stromschiene zur Zuführung eines Versorgungsstroms zu der elektrischen Schaltung. Zu den einzelnen Verbrauchern müssen dann jedoch gegebenenfalls ähnlich große Ströme abgeführt werden. Es ist daher bevorzugt, dass wenigstens ein Kontaktelement vorgesehen ist, das einen nahe dem Anschlussabschnitt der Stromschiene angeordnete Kontaktabschnitt aufweist, so dass ein elektrisches oder elektronisches Bauelement elektrisch mit dem Anschlussabschnitt der Stromschiene und dem Kontaktabschnitt verbindbar ist. Insbesondere kann der Kontaktabschnitt im Wesentlichen parallel zu dem Anschlussabschnitt verlaufen. Ein solches Kontaktelement ist also insofern von einem anderen Typ als das zuvor genannte Kontaktelement. Der Kontaktabschnitt kann dabei bevorzugt an einem freien Ende des Kontaktelements, insbesondere als Stift oder besonders bevorzugt als Kontaktzunge, ausgebildet sein. Auf der breiteren Fläche der Kontaktzunge ist ein entsprechender Anschluss des entsprechenden elektrischen oder elektronischen Bauelements mit der Kontaktzunge besonders einfach herstellbar. An dem nicht zur Verbindung mit dem elektrischen oder elektronischen Bauelement ausgebildeten Ende kann das Kontaktelement vorzugsweise zur Ausbildung einer Verbindung mit einer elektrischen Leitung ausgebildet sein. Bei der elektrischen oder elektronischen Baugruppe ist es dementsprechend bevorzugt, dass ein entsprechender Verbinder auf der Leiterplatte befestigt ist, und dass das elektrische oder elektronische Bauelement elektrisch sowohl mit dem Anschlussabschnitt der Stromschiene als auch dem Kontaktabschnitt verbunden ist. Auf diese Weise können die Versorgungsströme in einer oberhalb der Leiterplatte liegenden Ebene mit nur sehr geringen Verlusten geführt werden, so dass auf der Leiterplatte breite und/oder dicke Leiterbahnen weitestgehend vermieden werden können, was die Herstellung der Leiterplatte vereinfacht und deren Baugröße reduziert.

Sollen mehrere elektrische oder elektronische Bauelemente mit einem größeren Versorgungsstrom versorgt werden, muss der Anschlussabschnitt der Stromschiene eine entsprechende Größe aufweisen. Es ist dann bevorzugt, dass der Anschlussabschnitt der Stromschiene bügelförmig ausgebildet ist. Der Anschlussabschnitt kann so an beiden Enden an bzw. in dem Gehäuse des elektrischen Verbinders gehalten werden, wodurch sich insgesamt eine sehr stabile Anordnung ergibt. Eine solche Stromschiene kann daher sehr gut als Träger für das elektrische oder elektronische Bauelement dienen. Darüber hinaus kann eine entsprechende Spannung an beiden Enden der Stromschiene angelegt werden, so dass Spannungsabfälle über die Stromschiene auch bei größerer Länge einfacher ausgleichbar sind. Besonders bevorzugt ist der dann bügelförmige Anschlussabschnitt parallel zu der Leiterplatte orientiert.

Die Stromschiene kann grundsätzlich beliebig wenigstens teilweise im oder an dem Gehäuse gehalten sein. Insbesondere ist es möglich, dass die Stromschiene nur in entsprechende Kanäle in oder an dem Gehäuse eingedrückt bzw. eingepresst ist. Entsprechend können auch die Kontaktelemente in das Gehäuse eingedrückt bzw. eingepresst sein. Es ist jedoch bevorzugt, dass das Gehäuse ein Spritzgussteil ist und dass die Stromschiene wenigstens teilweise in das Gehäuse eingespritzt ist. Auf diese Weise ergibt sich eine besonders stabile Halterung der Stromschiene an bzw. in dem Gehäuse, wobei darüber hinaus auch komplizierter geformte Stromschienen, insbesondere in einem Bereich, in dem diese mit einer elektrischen Leitung verbindbar sind, in das Gehäuse einbringbar sind.

Weiterhin bevorzugt sind die Stromschiene und gegebenenfalls weitere vorhandene Kontaktelemente in dem elektrischen Verbinder einstückig ausgebildet. Sie weisen dann jeweils ein Ende auf, mit dem sie mit elektrischen Leitungen verbindbar sind. Auf diese Weise wird eine besonders einfache Herstellung des erfindungsgemäßen elektrischen Verbinders ermöglicht. Insbesondere können die Stromschiene und die Kontaktelemente durch Stanzverfahren mit gegebenenfalls folgendem Biegen einfach hergestellt werden.

Grundsätzlich kann der elektrische Verbinder so ausgebildet sein, dass die elektrischen Leitungen unlösbar mit der Stromschiene oder gegebenenfalls weiteren Kontaktelementen in dem Verbinder verbindbar sind, wobei unter "unlösbar" verstanden wird, dass zur Trennung der Verbindung Werkzeuge oder für die normale Verwendung untypisch große Kräfte und/oder Temperaturen notwendig sind. Insbesondere können die Enden für Lötverbindungen oder als Schneidklemme ausgebildet sein. Es ist jedoch bevorzugt, dass der Verbinder als Steckverbinder ausgebildet ist und die Stromschiene und/oder das Kontaktelement mit einem Steckkontaktelement verbunden oder an einem Ende als Steckkontakt ausgebildet sind. Insbesondere können die Stromschiene und/oder das Kontaktelement mit dem an einem Ende angeordneten Steckkontakt einstückig ausgebildet sein. Auf diese Weise kann die elektrische oder elektronische Baugruppe unabhängig von der Verkabelung gefertigt und beispielsweise in ein Fahrzeug eingebaut werden, wobei erst in einem späteren Stadium die elektrischen Verbindungen einfach durch Herstellen einer Steckverbindung mit einem komplementären Steckverbinder herstellbar sind. Dabei kann insbesondere das Gehäuse des erfindungsgemäßen Verbinders zur Herstellung einer Steckverbindung ausgebildet sein und entsprechende Führungselemente aufweisen.

Als elektrische oder elektronische Bauelemente, die mit der Stromschiene elektrisch verbindbar sind, können grundsätzlich beliebige elektrische oder elektronische Bauelemente, insbesondere elektrische oder elektronische Schalter, verwendet werden. Dabei kann es sich insbesondere um integrierte Schaltungen handeln, die in einem entsprechenden IC-Gehäuse verpackt sind. Es ist jedoch bevorzugt, dass das mit der Stromschiene elektrisch verbundene elektrische oder elektronische Bauelement eine unverpackte integrierte Schaltung ist. Solche Bauelemente werden auch als "bare dies" bezeichnet. Da solche Bauelemente sehr klein sind, kann ein besonders kompakter Aufbau der elektrischen Baugruppe erzielt werden. Zum Schutz der unverpackten integrierten Schaltungen kann auf diese nach Herstellung der elektrischen Verbindungen bevorzugt eine Schutzschicht aufgebracht werden, die insbesondere unter Verwendung entsprechender Lacke oder entsprechender Gele, insbesondere selbstheilender Gele, beispielsweise auf der Basis von Silikongelen, herstellbar ist.

Grundsätzlich können die Bauelemente dabei normal kontaktierbare Bauformen aufweisen, es können jedoch auch Bauelemente für Flip-Chip-Kontaktierung verwendet werden.

Die Erfindung wird im Weiteren beispielhaft anhand der Zeichnungen weiter erläutert. Es zeigen:
- Fig. 1: eine schematische Seitenansicht einer elektronischen Baugruppe mit einem Steckverbinder nach einer bevorzugten Ausführungsform der Erfindung in der in Fig. 3 gezeigten Richtung B, wobei zur besseren Darstellung ein Gehäuse des Steckverbinders transparent dargestellt ist,
- Fig. 2: eine schematische teilweise Schnittansicht der elektronischen Baugruppe in Fig. 1 entlang der Ebene A,
- Fig. 3: eine schematische Draufsicht auf die elektronische Baugruppe in Fig. 1,
- Fig. 4: eine schematische Seitenansicht des Steckverbinders in Fig. 1 in Richtung B,
- Fig. 5: eine Schnittansicht durch den Steckverbinder in Fig. 4 entlang der Ebene A, und
- Fig. 6: eine schematische Ansicht des Steckverbinders in Fig. 4, der teilweise in den Ebenen C, D und E geschnitten ist.

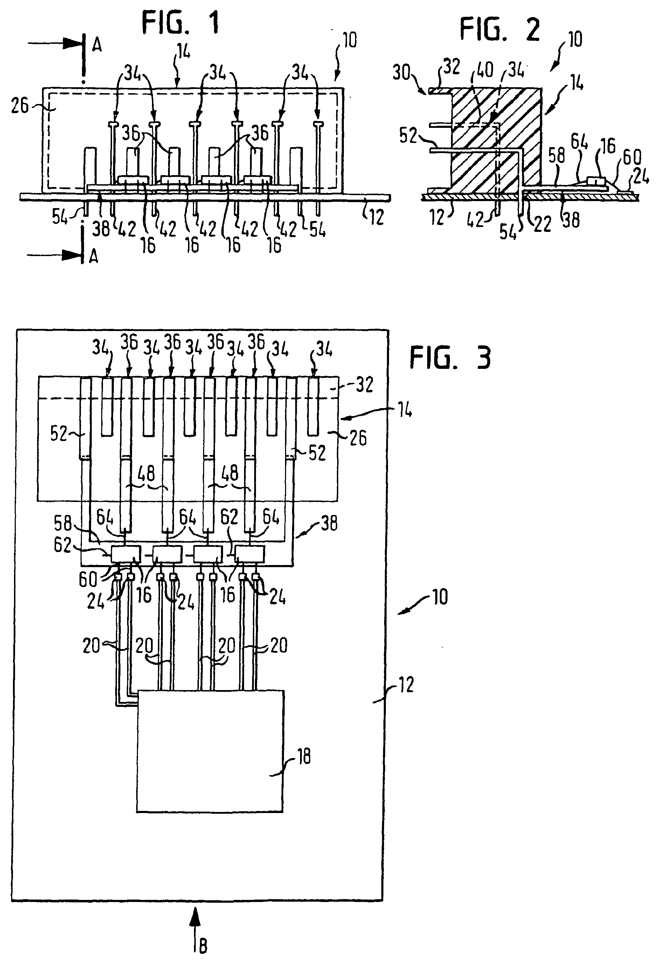

In den Fig. 1 bis 3 umfasst eine elektronische Baugruppe 10 nach einer bevorzugten Ausführungsform der Erfindung eine Leiterplatte 12, einen darauf befestigten elektrischen Steckverbinder 14, mehrere, im Beispiel vier, auf dem Steckverbinder 14 angeordnete integrierte Schaltungen 16, einen auf der Leiterplatte 12 ausgebildeten Schaltungsblock 18 sowie auf der Leiterplatte 12 gebildete Leiterbahnen 20, die die integrierten Schaltungen 16 mit dem Schaltungsblock 18 verbinden.

Bei der Leiterplatte 12 handelt es sich um eine konventionelle Leiterplatte, die Bohrungen 22 zur Durchkontaktierung, d.h. zur Aufnahme von Kontaktelementen, insbesondere Kontaktstiften, aufweist, von denen aus in den Figuren nicht gezeigte, auf die Leiterplatte 12 aufgedruckte konventionelle Leiterbahnen mit einer Dicke von etwa 35µm zu dem Schaltungsblock 18 führen. Diese Leiterbahnen können ein- oder beidseitig auf der Leiterplatte 12 ausgebildet sein.

Die ebenfalls konventionell auf die Leiterplatte 12 aufgedruckten Leiterbahnen 20 mit einer Dicke von 35 µm enden in Kontaktierungsflächen 24, auf denen Anschlüsse der integrierten Schaltungen 16 zur Kontaktierung verlötbar sind.

Der Schaltungsblock 18 ist in den Figuren nur grob schematisch dargestellt und kann eine Vielzahl von elektronischen Bauelementen umfassen. Insbesondere enthält der Schaltungsblock 18 einen Mikroprozessor, der zur Ansteuerung der integrierten Schaltungen 16 dient. Hierzu weist der Schaltungsblock 18 weiterhin entsprechende Ein- bzw. Ausgänge auf, die mit den Leiterbahnen 20 verbunden sind.

Der Schaltungsblock 18 bildet zusammen mit den über die Leiterbahnen 20 angeschlossenen integrierten Schaltungen 16 eine elektronische Schaltung der elektronischen Baugruppe 10, mittels derer vier verschiedene Verbraucher unabhängig voneinander ansteuerbar sind.

Der Steckverbinder 14 dient zum Anschluss elektrischer Leitungen an die elektronische Baugruppe 10 und ist auf der Leiterplatte 12 mittels in den Figuren nicht gezeigter Rastelemente an ebenfalls in den Figuren nicht gezeigten komplementären Rastelementen auf der Leiterplatte 12 gehalten.

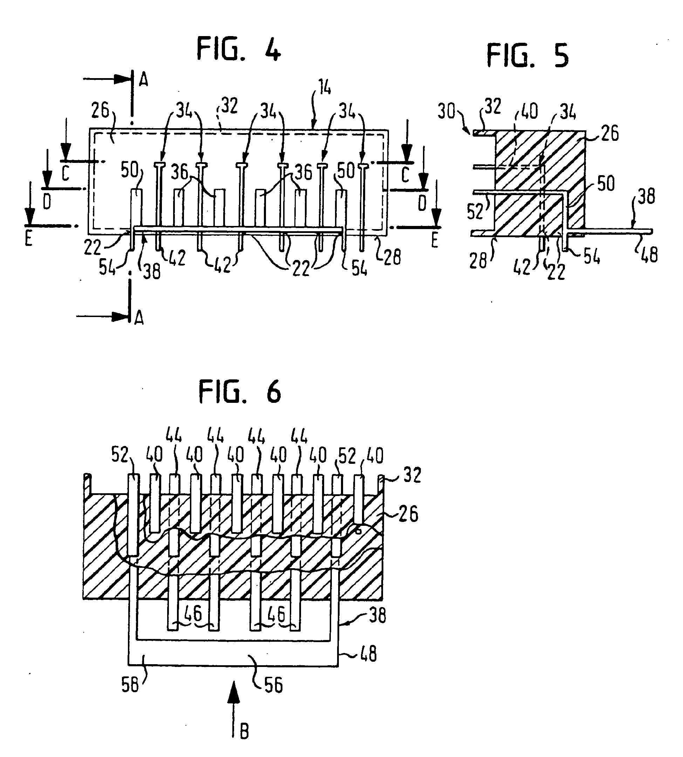

Der Steckverbinder 14 ist in den Fig. 4 bis 6 genauer gezeigt.

Der Steckverbinder 14 umfasst ein im Beispiel quaderförmiges Gehäuse 26 aus Kunststoff, das im Spritzgussverfahren hergestellt ist. Das Gehäuse weist eine im Folgenden als Unterseite 28 bezeichnete Oberfläche auf, mit der das Gehäuse 26 auf der Leiterplatte 12 aufliegt, wenn es an dieser befestigt ist.

Weiterhin umfasst das Gehäuse 26 an einer an die Unterseite 28 angrenzenden Seitenfläche, die im Folgenden als Steckerseite 30 bezeichnet wird, einen umlaufenden Kragen 32 auf, der eine Führung und Aufnahme für einen entsprechenden Teil eines in den Figuren nicht gezeigten, mit externen Leitungen bzw. Kabeln verbundenen, komplementären Steckverbinders bildet, der so in einer Steckrichtung parallel zur Leiterplatte 12 in den Steckverbinder 14 steckbar ist.

In dem Gehäuse 26 sind mehrere, im Beispiel sechs, erste Kontaktelemente 34, mehrere, im Beispiel vier, zweite Kontaktelemente 36 sowie eine Stromschiene 38 angeordnet.

Die ersten Kontaktelemente 34 sind in einer Richtung parallel zu der Unterseite 28 in gleichen Abständen und parallel zueinander angeordnet.

Die einstückig ausgebildeten ersten Kontaktelemente 34 weisen jeweils zwei im Wesentlichen rechtwinklig zueinander orientierte Abschnitte auf (vgl. Fig. 2 und 5), von denen ein als erste Steckkontaktzunge ausgebildeter Abschnitt 40 einen im Wesentlichen flachen, rechteckigen Querschnitt aufweist und teilweise auf der Steckerseite 30 innerhalb des Kragens 32 aus dem Gehäuse 26 in einer Richtung parallel zu der Leiterplatte 12 herausragt, so dass er als erste Steckkontaktzunge 40 für eine Steckverbindung mit einer entsprechenden Kontakthülse des komplementären Steckverbinders dienen kann. Der andere Abschnitt ist als erster Kontaktstift 42 ausgebildet und ragt so weit aus der Unterseite 28 des Gehäuses 26 heraus, dass der erste Kontaktstift 42 in einer zu der Längsrichtung des ersten Kontaktstifts 42 parallelen Einführrichtung in eine der Bohrungen 22 in der Leiterplatte 12 einführbar und dort durch Verlötung befestigbar bzw. mit einer Leiterbahn elektrisch verbindbar ist.

Die zweiten Kontaktelemente 36 sind ebenfalls in der Richtung parallel zu der Unterseite 28 in gleichen Abständen und parallel zueinander angeordnet, wobei sie jedoch in der Richtung parallel zu der Unterseite 28 bzw. längs der Steckerseite 30 zu den ersten Kontaktelementen versetzt sind.

Die zweiten Kontaktelemente 36 sind ebenfalls einstückig ausgebildet und weisen drei in Form einer Stufe angeordnete Abschnitte auf, die jeweils denselben flachen, rechteckigen Querschnitt aufweisen. Ein erster dieser Abschnitte ist als zweite Steckkontaktzunge 44 ausgebildet und verläuft im Wesentlichen parallel zu den ersten Steckkontaktzungen 40, jedoch gegenüber diesen in Richtung auf die Unterseite 28 des Gehäuses 26 zu versetzt. Die zweiten Steckkontaktzungen 44 der zweiten Kontaktelemente 36 sind somit sowohl in einer Richtung orthogonal zu der Leiterplatte 12 als auch in einer Richtung parallel dazu relativ zu den ersten Steckkontaktzungen 40 der ersten Kontaktelemente 34 versetzt angeordnet.

Der zweite, mittlere Abschnitt der zweiten Kontaktelemente 36 verläuft im Wesentlichen orthogonal zu der Unterseite 28 des Gehäuses 26, um dann in den dritten Abschnitt an dem freien Ende überzugehen, der als Kontaktzunge 46 ausgebildet ist. Die Kontaktzunge 46 verläuft parallel zu der Unterseite 28 des Gehäuses 26 und ragt auf einer der Steckerseite 30 gegenüberliegenden Seite aus dem Gehäuse 26 heraus.

Die zweiten Kontaktelemente 36 weisen einen Querschnitt auf, der entsprechend vorgegebenen Stromstärken für Versorgungsströme für in den Figuren nicht gezeigte elektrische Verbraucher dimensioniert sind und insbesondere gegebenenfalls einen größeren Strom tragen können als die ersten Kontaktstifte 42 der ersten Kontaktelemente 34. Im Beispiel haben sie einen Querschnitt von etwa 1 mm x 4 mm.

Die Stromschiene 38 umfasst einen Bügelabschnitt 48, der im Wesentlichen parallel zu der Unterseite 28 des Gehäuses 26 und damit orthogonal zu der Richtung der ersten Kontaktstifte 42 bzw. der Einführrichtung orientiert ist, zwei im Wesentlichen orthogonal zu der Fläche des Bügelabschnitts 48 verlaufende Verbindungsabschnitte 50 und zwei dritte Steckkontaktzungen 52 auf, die im Wesentlichen parallel zu den zweiten Steckkontaktzungen 44 in etwa gleicher Höhe verlaufen und etwa gleich weit innerhalb des Kragens 32 auf der Steckerseite 30 des Gehäuses 26 aus diesem austreten und so zur Verbindung mit Steckhülsen des komplementären Steckverbinders dienen können.

Weiterhin sind an der Stromschiene 38 zweite Kontaktstifte 54 ausgebildet, die den gleichen Querschnitt aufweisen wie die ersten Kontaktstifte 42 und zu diesen parallel verlaufen. Auch die zweiten Kontaktstifte 54 sind in der Einführrichtung in entsprechende Bohrungen 22 in der Leiterplatte 12 einführbar und dort zur Kontaktierung mit entsprechenden Leiterbahnen verlötbar.

Der Bügelabschnitt 48 der Stromschiene 38 weist einen außerhalb des Gehäuses 26 angeordneten U-förmigen Anschlussabschnitt 58 auf, dessen Mittelabschnitt gegenüber den seitlichen Schenkeln verbreitert ist und im Beispiel eine Breite von etwa 7 mm bei einer Dicke von etwa 1mm aufweist. Der Anschlussabschnitt 58 ist dabei in der gleichen Ebene angeordnet, wie die Kontaktzungen der zweiten Kontaktelemente 36 und schließen diese zusammen mit dem Gehäuse 26 in der Ebene des Anschlussabschnitts 58 ein (vgl. Fig. 5 und 6).

Der Anschlussabschnitt 58 verläuft im Wesentlichen parallel zu der Unterseite 28 des Gehäuses und damit, wenn der Steckverbinder 14 auf der Leiterplatte 12 gehalten ist, im Wesentlichen parallel zu der Leiterplatte 12. Er ist von dieser, im Beispiel mit einem Abstand von etwa 1 mm, beabstandet. Der Anschlussabschnitt 58 kann jedoch in einem anderen Ausführungsbeispiel auch direkt auf der Leiterplatte 12 aufsitzen.

Auf einem Mittelabschnitt 56 des Anschlussabschnitts 58 sind die integrierten Schaltungen 16 in gleichen Abständen angeordnet.

Bei den integrierten Schaltungen 16 handelt es sich um unverpackte integrierte Schaltungen, die aufgrund des fehlenden Gehäuses sehr kleine Dimensionen aufweisen. Die integrierten Schaltungen 16 bilden elektronische Schalter, die mit zwei Steueranschlüssen 60 mit den Kontaktierungsflächen 24 auf der Leiterplatte 12 verbunden sind. Ein Stromeingang 62 ist jeweils, in den Figuren nur schematisch gezeigt, mit dem Anschlussabschnitt 58 zur Zuführung von Strom verbunden, während ein Stromausgang 64 jeweils mit einer der Kontaktzungen 48 der zweiten Kontaktelemente 36, die aus dem Gehäuse 26 hervorragen, verbunden sind.

Die Stromschiene 38 bzw. der Anschlussabschnitt 58 dient weiterhin als Träger für die integrierten Schaltungen 16, die darauf mit einem geeigneten Kleber befestigt sind.

Der Anschlussabschnitt 58 bildet daher mit den Kontaktzungen 46 der zweiten Kontaktelemente 36 und den integrierten Schaltungen 16 räumlich gesehen eine zweite, von der Leiterplatte beabstandete Schaltungsebene.

Zum Schutz der integrierten Schaltungen 16 sind diese mit einem in den Figuren nicht gezeigten isolierenden und mechanisch schützenden Lack versehen. In einem anderen Ausführungsbeispiel kann statt des Lacks ein Gel, beispielsweise auf Silikonbasis, haubenartig auf die integrierten Schaltungen 16 aufgebracht werden, so dass diese hermetisch eingeschlossen und gegen Feuchtigkeit und mechanische Einflüsse geschützt wären.

Zur Herstellung der elektronischen Baugruppe 10 werden zunächst die Leiterplatte 12 mit dem Schaltungsblock 18 und der Steckverbinder 14 hergestellt. Sodann werden auf den Anschlussabschnitt 58 des Steckverbinders 14 die integrierten Schaltungen 16 aufgeklebt und der Stromeingang 62 mit dem Anschlussabschnitt 58 und der Stromausgang 64 mit den Kontaktzungen der zweiten Kontaktelemente 36 verlötet. In einem folgenden Schritt wird dann der Steckverbinder 14 auf die Leiterplatte 12 gesteckt und dort verrastet. Dabei werden die ersten und zweiten Kontaktstifte 42 bzw. 54 in der Einführrichtung parallel zu den Kontaktstiften in die entsprechenden Bohrungen 22 bewegt. Sodann werden zum einen die ersten und zweiten Kontaktstifte 42 bzw. 54 mit entsprechenden Leiterbahnen und die Steueranschlüsse 60 der integrierten Schaltungen 16 mit den Kontaktierungsflächen 24 auf der Leiterplatte 12 verlötet. Das Aufbringen des Lacks auf die integrierten Schaltungen kann entweder in dem Stadium erfolgen, in dem der Steckverbinder 14 noch nicht auf der Leiterplatte 12 befestigt ist, oder nach der Befestigung auf der Leiterplatte 12.

Die so hergestellte elektronische Baugruppe 10 kann nun einfach zur Steuerung von Versorgungsströmen von Verbrauchern verwendet werden, indem ein komplementärer Steckverbinder auf den Steckverbinder 14 aufgesteckt wird, wobei, beispielsweise bei Verwendung in einem Kraftfahrzeug, die dritten Steckkontaktzungen 52 mit einem Pluspol der Autoelektrik verbunden werden und die zweiten Steckkontaktzungen 44 mit den entsprechenden Verbrauchern. Über die zweiten Kontaktstifte 54 der Stromschiene 38 wird der Schaltungsblock 18 gleichfalls mit Spannung versorgt. Über die ersten Kontaktelemente 34 bzw. die ersten Kontaktzungen 40 können dem Schaltungsblock 18 Signale zugeführt werden, der entsprechend diesen Signalen über die Leiterbahnen 20 und die Steueranschlüsse 60 die integrierten Schaltungen 16 ansteuert, die daraufhin die positive Spannung an ihren Stromeingängen 62 auf die Stromausgänge 64 und damit die Verbraucher schalten oder die elektrische Verbindung trennen.

Auf diese Weise brauchen die Leiterbahnen 20 und die anderen, auf der Leiterplatte 12 vorhandenen Leiterbahnen nur für die Leitung von Signal bzw. Steuerströmen ausgelegt zu werden, so dass diese schmal und dünn ausgebildet sein können.

Die Führung der vergleichsweise großen Verbraucherströme hingegen erfolgt allein über die Stromschiene 38, die im Beispiel einen Querschnitt innerhalb des Gehäuses von 1 mm x 4 mm hat und so auch größere Verbraucherströme weitgehend verlustfrei tragen kann. Gleichzeitig kann der Raum unter dem Anschlussabschnitt 58 für Leiterbahnen auf der Leiterplatte 12 genutzt werden, was jedoch aus Gründen der Übersichtlichkeit in den nur schematischen Figuren nicht gezeigt ist.

In den Figuren ist der Abstand zwischen dem Steckverbinder 12 und dem Schaltungsblock 18 der besseren Übersichtlichkeit halber sehr groß gewählt. Bei einer realen Baugruppe sind der Steckverbinder 12 und der Schaltungsblock 18 in einem möglichst kleinen Abstand angeordnet, so dass sich eine sehr kompakte Baugruppe 10 ergibt.

In einem anderen Ausführungsbeispiel sind die Steckkontaktzungen 40, 44 und 52 durch entsprechende Steckhülse zur Aufnahme von Kontaktzungen oder -stiften eines komplementären Steckverbinders ersetzt.

In einer weiteren Ausführungsform sind die zweiten Kontaktelemente und die in dem Gehäuse 26 befindlichen Abschnitte der Stromschiene linear ausgebildet und in entsprechende, parallel zu der Unterseite des Gehäuses 26 verlaufende Kanäle in dem Gehäuse 26 eingeschoben.

### Bezugszeichenliste

- 10: elektronische Baugruppe
- 12: Leiterplatte
- 14: Steckverbinder
- 16: integrierte Schaltungen
- 18: Schaltungsblock
- 20: Leiterbahnen
- 22: Bohrungen
- 24: Kontaktierungsflächen
- 26: Gehäuse
- 28: Unterseite
- 30: Steckerseite
- 32: Kragen
- 34: erste Kontaktelemente
- 36: zweite Kontaktelemente
- 38: Stromschienen
- 40: erste Steckkontaktzungen
- 42: erste Kontaktstifte
- 44: zweite Steckkontaktzungen
- 46: Kontaktzungen
- 48: Bügelabschnitt
- 50: Verbindungsabschnitt
- 52: dritte Steckkontaktzungen
- 54: zweite Kontaktstifte
- 56: Mittelabschnitt
- 58: Anschlussabschnitt
- 60: Steueranschlüsse
- 62: Stromeingänge
- 64: Stromausgänge

## Patentansprüche

1. Elektrische oder elektronische Baugruppe mit einer Leiterplatte (12), einer darauf wenigstens teilweise angeordneten elektrischen oder elektronischen Schaltung (16, 18) und einem auf der Leiterplatte (12) befestigten elektrischen Verbinder (14) mit einem auf der Leiterplatte (12) befestigbaren Gehäuse (26), und einer wenigstens teilweise in oder an dem Gehäuse (26) angeordneten, mit einer elektrischen Leitung verbindbaren Stromschiene (38), die einen Anschlussabschnitt (58) aufweist,
wobei der Anschlussabschnitt (58) an einer Oberfläche der Leiterplatte (12) oder von der Oberfläche beabstandet so angeordnet ist, dass wenigstens ein elektrisches oder elektronisches Bauelement (16) der Schaltung (16, 18) mit dem Anschlussabschnitt (58) der Stromschiene (38) und einer Leiterbahn (20) auf der Leiterplatte (12) elektrisch verbunden ist.

2. Baugruppe nach Anspruch 1,
**gekennzeichnet durch**
wenigstens ein Kontaktelement (34) zur elektrischen Verbindung einer Leiterbahn (20) und/oder einer mit der Leiterbahn (20) elektrisch verbundenen Kontaktierungsfläche (24) mit wenigstens einer der elektrischen Leitungen.

3. Baugruppe nach Anspruch 2,
**dadurch gekennzeichnet,**
**dass** das Kontaktelement (34) zur Einführung in eine entsprechende Öffnung (22) der Leiterplatte (12) in einer Einführrichtung ausgebildet ist, und
**dass** der Anschlussabschnitt (58) der Stromschiene (38) im Wesentlichen orthogonal zur der Einführrichtung orientiert ist.

4. Baugruppe nach einem der vorhergehenden Ansprüche,
**dadurch gekennzeichnet,**
**dass** wenigstens ein Kontaktelement (36) vorgesehen ist, das einen nahe dem Anschlussabschnitt (58) der Stromschiene (38) angeordneten Kontaktabschnitt (46) aufweist, so dass ein elektrisches oder elektronisches Bauelement (16) elektrisch mit dem Anschlussabschnitt (58) der Stromschiene (38) und dem Kontaktabschnitt (46) verbindbar ist.

5. Baugruppe nach einem der vorhergehenden Ansprüche,
**dadurch gekennzeichnet,**
**dass** der Anschlussabschnitt (58) der Stromschiene (38) bügelförmig ausgebildet ist.

6. Baugruppe nach einem der vorhergehenden Ansprüche,
**dadurch gekennzeichnet,**
**dass** das Gehäuse (26) ein Spritzgussteil ist und die Stromschiene (38) wenigstens teilweise in das Gehäuse (26) eingespritzt ist.

7. Baugruppe nach einem der vorhergehenden Ansprüche,
**dadurch gekennzeichnet,**
**dass** der elektrische Verbinder als Steckverbinder (14) ausgebildet ist und die Stromschiene (38) und/oder das Kontaktelement (34, 36) mit einem Steckkontaktelement verbunden oder an einem Ende als Steckkontakt ausgebildet sind.

8. Baugruppe nach Anspruch 1,
**dadurch gekennzeichnet,**
**dass** der Anschlussabschnitt (58) der Stromschiene (38) einen Träger für das elektrische oder elektronische Bauelement (16) bildet.

9. Baugruppe nach Anspruch 1 oder 8,
**dadurch gekennzeichnet,**
**dass** auf der Leiterplatte (12) ein elektrischer Verbinder (14) nach Anspruch 3 befestigt ist, dessen Kontaktelement (34) in eine entsprechende Öffnungen der Leiterplatte (12) eingeführt und dort verlötet ist, und
**dass** der Anschlussabschnitt (58) der Stromschiene (38) im Wesentlichen orthogonal zur der Einführrichtung orientiert ist.

10. Baugruppe nach Anspruch 4,
**dadurch gekennzeichnet,**
**dass** das elektrische oder elektronische Bauelement (16) elektrisch sowohl mit dem Anschlussabschnitt (58) der Stromschiene (38) als auch dem Kontaktendabschnitt verbunden ist.

11. Baugruppe nach einem der Ansprüche 1 oder 8-10,
**dadurch gekennzeichnet,**
**dass** das mit der Stromschiene (38) verbundene elektrische oder elektronische Bauelement (16) eine unverpackte integrierte Schaltung ist.

## Claims

1. An electrical or electronic component assembly having a circuit board (12), an electrical or electronic circuit (16, 18) at least partly arranged thereon and an electrical connector (14 fastened to the circuit board (20),
having a housing (26) which can be fastened to the circuit board (12) and a current rail (38) which is at least partly arranged in or at the housing (26), which can be connected to an electrical lead and which has a connection section (58),
wherein the connection section (58) is arranged at a surface of the circuit board (12) or with a spacing from said surface such that at least one electrical or electronic component (16) of the circuit (16, 18) is electrically connected to the connection section (58) of the current rail (38) and to a conductive track (20) on the circuit board (12).

2. An assembly in accordance with claim 1,
**characterized by**
at least one contact element (34) for the electrical connection of a conductive track (20) and/or of a contacting surface (24) which is electrically connected to the conductive track (20) to at least one of the electrical leads.

3. An assembly in accordance with claim 2,
**characterized in that**
the contact element (34) is designed for introduction in an introduction direction into a corresponding opening (22) of the circuit board (12); and
**in that** the connection section (58) of the current rail (38) is oriented substantially orthogonal to the introduction direction.

4. An assembly in accordance with at least one of the preceding claims,
**characterized in that**
at least one contact element (36) is provided which has a contact section (46) which is arranged close to the connection section (58) of the current rail (38) so that an electrical or electronic component (16) can be electrically connected to the connection section (58) of the current rail (38) and to the contact section (46).

5. An assembly in accordance with at least one of the preceding claims,
**characterized in that**
the connection section (58) of the current rail (38) is hoop-shaped.

6. An assembly in accordance with at least one of the preceding claims,
**characterized in that**
the housing (26) is an injection moulded part and the current rail (38) is at least partly injection moulded into the housing (26).

7. An assembly in accordance with at least one of the preceding claims,
**characterized in that**
the electrical connector is designed as a plug connector (14) and the current rail (38) and/or the contact element (34, 36) is/are connected to a plug contact element or formed at one end as a plug contact.

8. An assembly or electronic component assembly in accordance with claim 1,
**characterized in that**
the connection section (58) of the current rail (38) forms a carrier for the electrical or electronic component (16).

9. An assembly in accordance with claim 1 or claim 8,
**characterized in that**
an electrical connector (14) in accordance with claim 3, the contact element (34) of which is introduced into a corresponding opening of the circuit board (12) and is soldered there, is secured to the circuit board (12); and
**in that** the connection section (58) of the current rail (38) is oriented substantially orthogonally to the introduction direction.

10. An assembly in accordance with claim 4,
**characterized in that**
the electrical or electronic component (16) is electrically connected both to the connection section (58) of the current rail (38) and to the end section of the contact.

11. An assembly in accordance with any one of the claims 1 or 8 to 10,
**characterized in that**
the electrical or electronic component (16) which is connected to the current rail (38) is an unpacked integrated circuit.

## Revendications

1. Bloc électrique ou électronique comprenant une carte de circuits imprimés (12), un circuit électrique ou électronique au moins partiellement aménagé par-dessus (16, 18) et un connecteur électrique (14) fixé sur la carte de circuits imprimés (12) avec un boîtier (26) qui peut être fixé sur la carte de circuits imprimés (12), et une barre conductrice (38), agencée au moins partiellement dans ou sur le boîtier (26) et qui peut être connectée à une ligne électrique, qui présente une section de connexion (58), laquelle section de connexion (58) est agencée sur une surface de la carte de circuits imprimés (12) ou à distance de la surface de manière à connecter électriquement au moins un composant électrique ou électronique (16) du circuit (16, 18) à la section de connexion (58) de la barre conductrice (38) et à une piste conductrice (20) de la carte de circuits imprimés (12).

2. Bloc selon la revendication 1, **caractérisé par** au moins un élément de contact (34) pour la connexion électrique d'une piste conductrice (20) et/ou une surface d'établissement de contact (24) connectée électriquement à la piste conductrice (20) avec au moins une des lignes électriques.

3. Bloc selon la revendication 2, **caractérisé en ce que** l'élément de contact (34) à introduire dans un orifice correspondant (22) de la carte de circuits imprimés (12) se présente dans une direction d'introduction, et **en ce que** la section de connexion (58) de la barre conductrice (38) est orientée de manière sensiblement orthogonale à la direction d'introduction.

4. Bloc selon l'une quelconque des revendications précédentes, **caractérisé en ce que** l'on prévoit au moins un élément de contact (36), qui présente une section de contact (46) agencée près de la section de connexion (58) de la barre conductrice (38), de manière à pouvoir connecter électriquement un composant électrique ou électronique (16) à la section de connexion (58) de la barre conductrice (38) et à la section de contact (46).

5. Bloc selon l'une quelconque des revendications précédentes, **caractérisé en ce que** la section de connexion (58) de la barre conductrice (38) se présente sous la forme d'un étrier.

6. Bloc selon l'une quelconque des revendications précédentes, **caractérisé en ce que** le boîtier (26) est une pièce moulée par injection et la barre conductrice (38) est injectée au moins partiellement dans le boîtier (26).

7. Bloc selon l'une quelconque des revendications précédentes, **caractérisé en ce que** le connecteur électrique se présente sous la forme d'un connecteur d'enfichage (14) et la barre conductrice (38) et/ou l'élément de contact (34, 36) sont connectés à un élément de contact d'enfichage ou se présentent sous la forme d'un contact d'enfichage à une extrémité.

8. Bloc selon la revendication 1, **caractérisé en ce que** la section de connexion (58) de la barre conductrice (38) forme un support pour le composant électrique ou électronique (16).

9. Bloc selon la revendication 1 ou 8, **caractérisé en ce que** l'on fixe sur la carte de circuits imprimés (12) un connecteur électrique (14) selon la revendication 3, dont l'élément de contact (34) est introduit dans un orifice correspondant de la carte de circuits imprimés (12) et y est connecté par brasage, et **en ce que** la section de connexion (58) de la barre conductrice (38) est orientée de manière sensiblement orthogonale à la direction d'introduction.

10. Bloc selon la revendication 4, **caractérisé en ce que** le composant électrique ou électronique (16) est connecté électriquement tant à la section de connexion (58) de la barre conductrice (38) qu'à la section terminale de contact.

11. Bloc selon l'une quelconque des revendications 1 ou 8 à 10, **caractérisé en ce que** le composant électrique ou électronique (16) connecté à la barre conductrice (38) est un circuit intégré non conditionné.
